# EUROPEAN PATENT APPLICATION

(11) **EP 1 585 018 A2**
(43) Date of publication of application: **12.10.2005**
(21) Application number: 05007525.8
(22) Date of filing: 06.04.2005
(51) Int. Cl.: G06F 3/033

(54) **Touch panel input device**

(30) Priority: 06.04.2004 JP 2004111719
(71) Applicant: SMK Corporation, Tokyo 142-8511 (JP)
(72) Inventor: Nakayama, Naomi, Nei-gun Toyoama 939-2366 (JP); Imai, Kazuo, Nei-gun Toyoama 939-2366 (JP)
(74) Representative: HOFFMANN EITLE

(57) **Abstract**

A plurality of signal conductor wires connected respectively to signal lead patterns, and a plurality of power conductor wires connected respectively to power lead patterns are formed on a connector tail and are arranged to extend in a leading-out direction. A pitch of the power conductor wires is twice larger than a pitch of the signal conductor wires. A sufficient insulating gap is secured between the adjacent power conductor wires, and therefore there is no fear that the short-circuiting occur even when a high drive voltage is applied.

## Description

### BACKGROUND OF THE INVENTION

This invention relates to a touch panel input device in which when an input operation is applied to a touch panel , the touch panel is vibrated during this input operation so as to cause the operator to have an input operating feeling, and more particularly to a touch panel input device in which the touch panel is vibrated using a piezoelectric plate.

A touch panel input device is called a digitizer. When an operating area provided on a touch panel is pushed or operated for input purposes by a stylus pen or a finger, this input operation and an input operation position within the operating area are detected, and input detection signal, representing the input operation or the input operation position, is output to an external processing apparatus such as a personal computer.

There are known various touch panel input devices which are classified into the contact-type (as disclosed in JP-UM-A-3-6731), the resistance type ((as disclosed in JP-A-5-53715) and other types, depending on a method of detecting an input operation position. In any of these types, when an input operation is effected, a clear input operation feeling, such as a click feeling obtained in a push button switch, is not obtained, and therefore the operator could know the results of the operation only through the processing apparatus such as a personal computer, and therefore the operator is anxious about whether or not the input operation on the operating panel was actually recognized.

Therefore, the present Applicant has developed a touch panel input device in which a piezoelectric plate is fixedly secured to a touch panel so as to efficiently vibrate the touch panel without forming the whole of the device into a large size, thereby transmitting ah input operation feeling to the operator (see JP-A-2003-122507, for example).

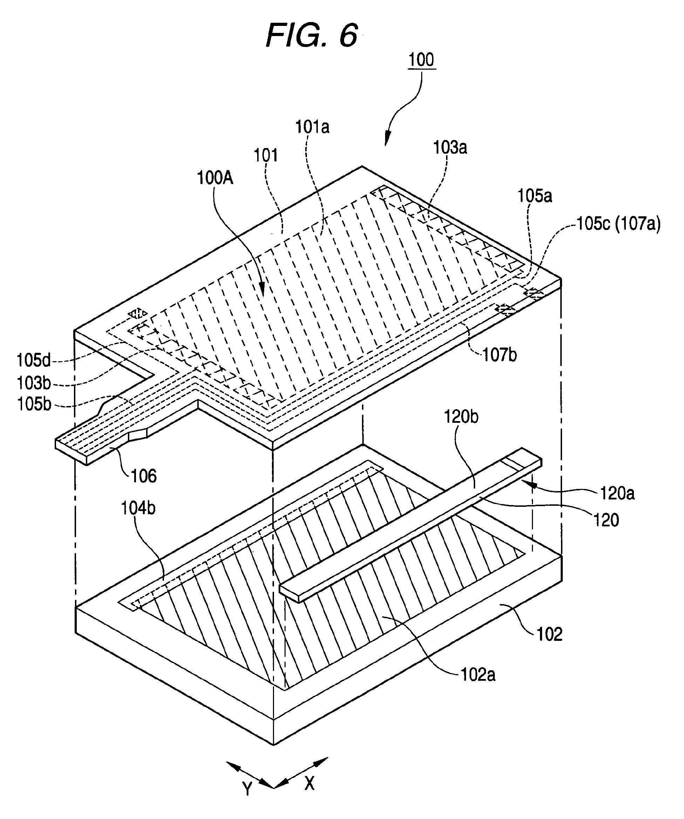

Fig. 6 shows this touch panel input device 100 employing the piezoelectric plate 120 serving as a vibrating part. A touch panel is provided with an operating panel 101 and a support board 102 which are stacked together with a small gap formed therebetween. An operating area 100A for detecting an input operation position is provided within the touch panel. The illustrated touch panel input device 100 is designed to detect an input operation position by a resistance sensitive method, and therefore conductive layers 101a and 102a, each formed of a resistance film of a uniform thickness, are formed respectively on opposed surfaces of the operating panel 101 and support board 102.

In Fig. 6, an X-energization electrode 103a and an X-ground electrode 103b are formed respectively at opposite side edge portions of the conductive layer 101a spaced from each other in a direction X. A Y-energization electrode (serving also as a drive electrode 120a of the piezoelectric plate (described later)) and a Y-ground electrode 104b are formed respectively at opposite side edge portions of the conductive layer 102a spaced from each other in a direction Y. These electrodes are connected respectively to signal lead patterns 105a, 105b, 105c and 105d formed and arranged on the operating panel 101, and are led to the exterior via a connector tail 106 formed integrally at a peripheral edge of the operating panel 101.

The strip-shape piezoelectric plate 120 is fixedly secured to that surface of the support board 102 facing the operating panel 101, and is disposed outside the periphery of the operating area 100A. A pair of drive electrodes 120a and 120b are formed on opposite sides (front and rear surfaces) of the strip-shape piezoelectric plate 120, and these drive electrodes are connected respectively to power lead pattern 107a (serving also as the signal lead pattern 105c) and 107b formed and arranged on the operating panel 101, and are led to the exterior via the connector tail 106 as described above for the signal lead patterns 105.

One end of the connector tail 106 is connected to an external control circuit via a connector (not shown) into which the connector tail 106 is inserted for connection purposes. With this construction, an input operation and an input operation position are detected, and also the vibration of the touch panel is controlled.

For detecting an input operation applied to the operating area 100A, a detection voltage is applied from the external control circuit to one of the conductive layers 101a and 102a via the signal lead patterns 105, then a potential of the other is detected via the signal lead patterns 105. When an input operation is performed with respect to the operation area 100A, the conductive layers 101a and 102a are contacted with each other at this input operation position, and are electrically connected together. As a result, an input detection signal, having an increasing potential, appears in the signal lead patterns 105 connected to the non-voltage-applied conductive layer 101a, 102a, so that the input operation is detected.

When the input operation is detected, a drive voltage is applied from the exterior to the pair of drive electrodes 120a and 120b via the power lead patterns 107a and 107b, so that the piezoelectric plate 120 is expanded and contracted to vibrates the whole of the touch panel including the operating panel 101 and the support board 102 to which the piezoelectric plate 120 is fixed, and as a result the operator can confirm from this vibration that the input operation has been entered.

Thereafter, the detection voltage is applied alternately to the X-energization electrode 103a and the Y-energization electrode 120a via the respective signal lead patterns 105a and 105c so as to form a fixed potential gradient alternately at the conductive layers 101a and 102a, and an input detection signal, representing the potential of the contact position (the input operation position), is output to the signal lead patterns 105 connected to the voltage-applied conductive layer 101a, 102a, and the input operation position in the directions X and Y is detected from this input detection signal.

In this touch panel input device 100, the signal lead patterns 105 and the power lead patterns 107 are connected to the external control circuit, using the single connector tail 106. The detection voltage applied to the signal lead patterns 105 at the time of detecting an input operation and an input operation position, as well as the potential of the input detection signal, is 3V to 5V. On the other hand, in some cases, the drive voltage, applied between the power lead patterns 107a and 107b so as to expand and contract the piezoelectric plate 120, is about 200V to about 400V. Therefore, when the power lead patterns 107a and 107b were arranged at the same pitch as the pitch of the signal lead patterns 105 in the connector tail 106, a sufficient insulating gap was not secured between the adjacent lead patterns, which has led to a possibility that the short-circuiting occurs therebetween.

By the use of the single connector tail 106, the lead patterns can be connected to the external control circuit by a single connector. However, since contacts which are provided in the connector are arranged at a predetermined pitch, the pitch of those contacts to be connected respectively to the power lead patterns 107 is equal to the pitch of those contacts corresponding respectively to the signal lead patterns 105. Therefore, when a high drive voltage was applied between the contacts, there was a fear that the short-circuiting occurred between the contacts of the connector.

Therefore, a study has been made of a method of decreasing the drive voltage for the piezoelectric plate 120 and a method of preparing separate connector tails for respectively leading the signal lead patterns 105 and the power lead patterns 107 to the exterior. However, in the former method, the touch panel can not be vibrated to such a degree as to enable the operator to perceive the vibration. In the latter method, the number of the component parts increases, and the two kinds of connectors must be prepared, and besides the wiring becomes complicated.

### SUMMARY OF THE INVENTION

This invention has been made in view of these problems of the conventional devices, and an object of the invention is to provide a touch panel input device in which signal lead patterns and power lead patterns are led to the exterior via a single connector tail, and also a sufficient insulating gap is secured between adjacent power conductor wires through which the power lead patterns are led to the exterior.

In order to solve the aforesaid object, the invention is characterized by having the following arrangement.
(1) A touch panel input device comprising:
   a touch panel having an operating area;
   an input position detector for detecting an input operation applied to the operating area, which includes a plurality of signal lead patterns which are arranged on the touch panel and through which a detection signal of the detected input operation is output;
   a piezoelectric plate that is secured to the touch panel and is adapted to expand and contract to vibrate the touch panel in response to a drive voltage that is generated based on the detection signal;
   a pair of power lead patterns that' are arranged an the touch panel and through which the *drive* voltage is applied to the piezoelectric plate; and
   a connector tail which includes a plurality of signal conductor wires connected respectively to the corresponding signal lead patterns, and a plurality of power conductor wires connected respectively to the corresponding power lead patterns,
   wherein the signal conductor wires and the power conductor wires are led from a peripheral edge of the touch panel and are arranged to extend in a leading-out direction,
   wherein a pitch of the power conductor wires is substantially twice larger than a pitch of the signal conductor wires. In other words, the pitch of the power conductor wires is substantially twice as large as a pitch of the signal conductor wires. However, it can also be sufficient, if the pitch of the power conductor wires is larger than the pitch of the signal conductor wires. In particular, the pitch of the power conductor wires can also be larger than twice the pitch of the signal conductor wires.
(2) The touch panel input device according to (1), wherein the input position detector detects an input operation position an the touch panel and outputs input detection signals representing the input operation position.
(3) The touch panel input device according to (1) or (2), wherein the piezoelectric plate includes a pair of drive electrodes to which the drive voltage is applied via the pair of power lead patterns.
(4) The touch panel input device according to at least on of (1) to (3), wherein a pair of the piezoelectric plates are secured to the touch panel.
(5) The touch panel input device according to at least one of (1) to (4), wherein
   the connector tail includes a plurality of conductor wires arranged at same pitch as the pitch of the signal conductor wires, and
   the plurality of conductor wires are alternately connected respectively to the power lead patterns to serve as the power conductor wires.
(6) The touch panel input device according to at least one of (1) to (5), wherein
   one end portion of the connector tail is bifurcated to provide e power cable portion having the power conductor wires and a signal cable portion having the signal conductor wires, and
   the power conductor wires an the power cable portion are electrically connected respectively to the power leadpatterns at one side of the touch panel to which the piezoelectric plate is secured, and the signal conductor wires an the signal cable portion are electrically connected respectively to the signal lead patterns at the other side of the touch panel facing away from the one side thereof.
(7) The touch panel input device according to at least one of (1) to (6), wherein
   one end portion of the connector tail is bifurcated to provide a power cable portion having the power conductor wires and a signal cable portion having the signal conductor wires, and
   the power conductor wires on the power cable portion are electrically connected respectively to the power lead patterns that are connected respectively to the drive electrodes of the pair of piezoelectric plates that are secured to the touch panel with the operation area between the pair of piezoelectric plates, and the signal conductor wires an the signal cable portion are electrically connected respectively to the signal lead patterns.
(8) The touch panel input device according to at least one of (1) to (7), wherein
   two power lead patterns connected respectively to one pair of the drive electrodes of respective one of the pair of piezoelectric plates are collectively connected respectively to one of the pairs of power conductor wires,
   two power lead patterns connected respectively to the other pair of the drive electrodes of the pair of piezoelectric plates are collectively connected to the other pair of power conductor wires, and
   the pair of piezoelectric plates secured to the touch panel are expanded and contracted by the drive voltage applied to the pairs of power conductor wires.
(9) The touch panel Input device according to at least one of (1) to (8), wherein
   two power lead Patterns connected respectively to a pair of the drive electrodes of the pair of piezoelectric plates are collectively connected respectively to one of the pairs of power conductor wires,
   two power lead patterns connected respectively to the other pair of the drive electrodes of the pair of piezoelectric plates are collectively connected to the other pair of power conductor wires, and
   the pair of piezoelectric plates secured to the touch panel are expanded and contracted by the drive voltage applied 15 to the pairs of power conductor wires.

In the invention, a sufficient insulating gap is secured between the adjacent power conductor wires, and therefore there is fear that the short-circuiting occurs. And besides, even in the case where contacts of a connector to which the connector tail is to be connected are arranged at the same pitch as the pitch of the signal conductor wires, the contacts are alternately connected to the power conductor wires, and therefore even when a high drive voltage is applied, the 2short-circuiting will not occur between the adjacent contacts, and a connector of a low withstanding pressure, designed to be connected to the signal lead wires, can be used.

In the invention, the connector tail, having the conductor wires arranged at the same pitch as the pitch of the signal conductor wires, can be used, and therefore a general-purpose connector tail can be used without the need for producing a special connector tail having conductor wires arranged thereon at different intervals.

In the invention, the power lead patterns and the signal lead patterns, can be arranged on the touch panel with a sufficient insulating gap formed between the adjacent lead patterns, without the need for considering the insulation between the power lead patterns and the signal lead patterns.

In the invention, the four power lead patterns, extending from the pair of piezoelectric plates, can be connected respectively to the corresponding power conductor wires at one concentrated position, and therefore the connecting operation can be effected easily. Particularly, in the process of connecting the power conductor wires by thermocompression welding, the power conductor wires can be connected respectively to the four power lead patterns while applying a uniform pressure thereto, and therefore all of the power conductor wires can be positively connected respectively to the power lead patterns without a variation in the applied pressure.

In the invention, the pair of piezoelectric plates can be expanded and contracted only by the pair of power conductor wires.

### BRIEF DESCRIPTION OF THE DRAWINGS

Fig. 1 is an exploded, perspective view showing the whole of a first embodiment of a touch panel input device 1 of the present invention.
Fig. 2 is a bottom view of the touch panel input device 1.
Fig. 3 is a partly-broken, perspective view showing a connecting portion for a connector tail 5.
Fig.4A is a plan view of the connector tail 5, with a protecting sheet 10b and a reinforcing sheet 10c removed, Fig. 4B is a side-elevational view of the connector tail 5, and Fig.4C is a bottom view of the connector tail 5, with a protecting sheet 10a removed.
Fig. 5 is a view explanatory of the wiring of signal lead patterns 12 and power lead patterns 13 in a touch panel 3, 4.
Fig. 6 is an exploded, perspective view showing a conventional touch panel input device 100.

### DETAILED DESCRIPTION OF PREFERRED EMBODIMENTS

### First Embodiment

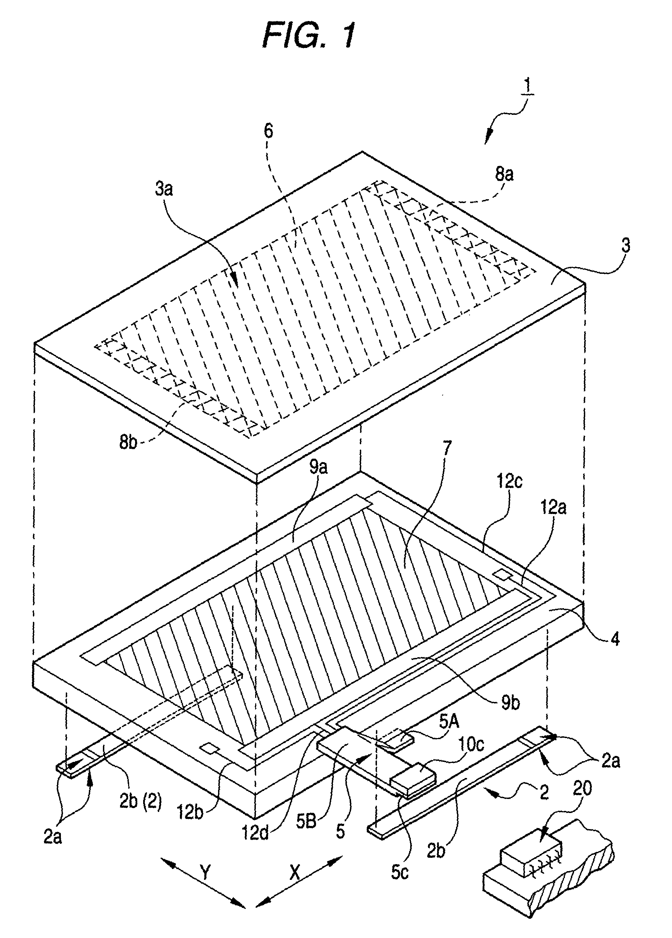

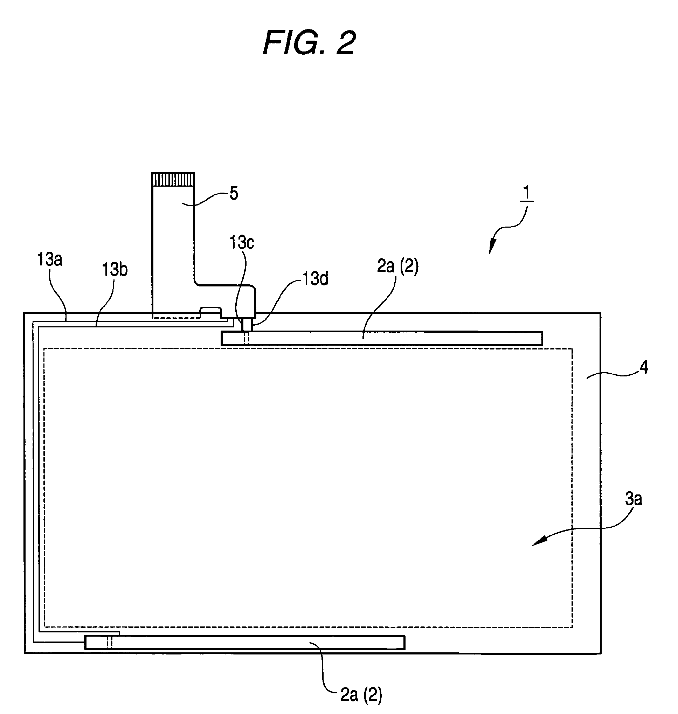

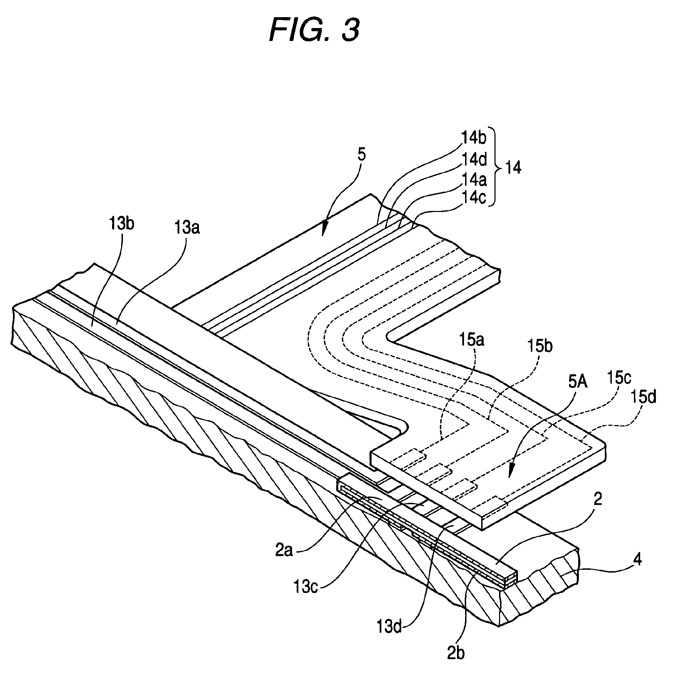

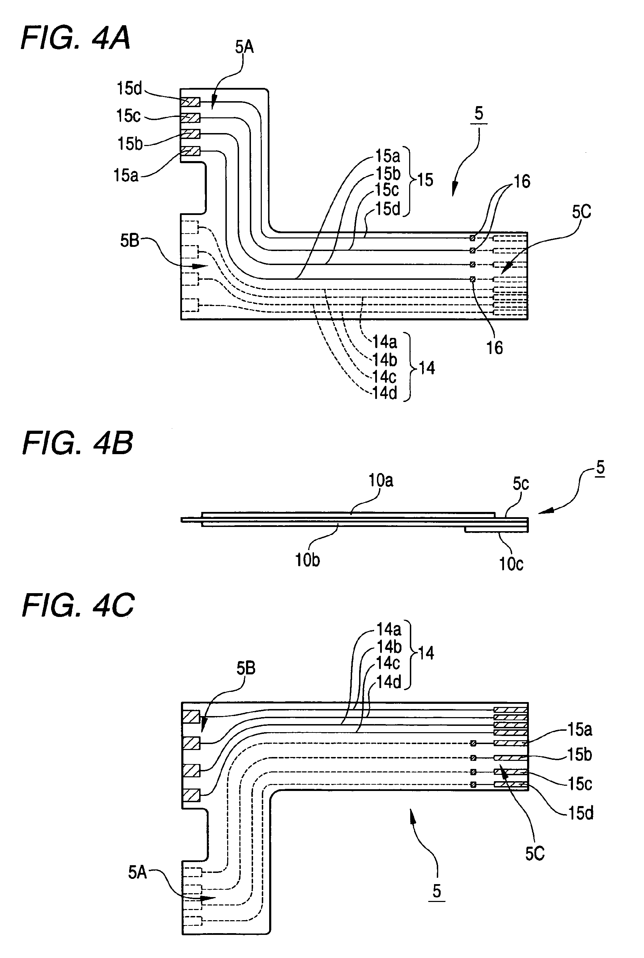

A first preferred embodiment of a touch panel input device 1 of the present invention will now be described with reference to Figs. 1 to 4. The touch panel input device 1 according to the embodiment is of the so-called resistance sensitive type in which a touch panel is formed by an operating panel 3 and a support board 4 which are stacked together with a small gap formed therebetween, and conductive layers, each formed of a resistance film of a uniform thickness (in which a uniform potential gradient can be formed), are affixed respectively to opposed surfaces of the operating panel 3 and support board 4. An input operation position is detected from a potential at a position of contact between the conductive layers. Fig. 1 is an exploded, perspective view showing the whole of the touch panel input device 1, Fig. 2 is a bottom view thereof, Fig. 3 is an enlarged perspective view showing a connecting portion for a connector tail 5, and Figs. 4A, 4B and 4C are a plan view, a side-elevational view and a bottom view of the connector tail 5, respectively.

The operating panel 3 is formed into a rectangular flexible sheet, using a transparent synthetic resin (here, PET (polyethylene terephthalate)), and a rectangular operating area 3a is provided within the periphery of the operating panel 3. The operating panel 3 is thus made of a transparent material so that an input operation can be applied to the operating area 3a while viewing a liquid crystal display panel (not shown) disposed internally of the support board 4.

The support board 4 includes a transparent board made of soda-lime glass, and is formed into a thin sheet having the same rectangular contour as that of the operating panel 3. The support board 4 serves to support the rear side of the operating panel 3 to which an input operation is applied, and hence this support board 4 is made of a material having a certain degree of rigidity.

The operating panel 3 and the support board 4 are stacked together in such a manner that the two are spaced a small distance from each other by an adhesive layer interposed between outer peripheral portions of their opposed surfaces. The movable conductive layer 6 and the fixed conductive layer 7 (each of which is a transparent conductive layer) are fixed respectively to the opposed surfaces of the operating panel 3 and support board 4, and have a uniform film thickness. Each of the movable conductive layer 6 and the fixed conductive layer 7 is made of ITO (indium-tin oxide), and is formed on the corresponding surface to have a uniform film thickness. A resistance value per unit length at any position of the conductive layer is the same.

Dot spacers (not shown), made of an insulative synthetic resin, are fixed to the fixed conductive layer 7 at predetermined intervals. The dot spacers are provided for preventing the movable conductive layer 6 and the fixed conductive layer 7 from contacting each other when the hand or other inadvertently touches part of the operating area 3a. The height of the dot spacers is smaller than the gap between the movable conductive layer 6 and the fixed conductive layer which are kept spaced from each other by the adhesive layer.

At the rear surface of the operating panel 3, an X-energization lead electrode 8a and an X-ground lead electrode 8b, electrically connected to the movable conductive layer 6, are printed respectively on opposite side edge portions of the movable conductive layer 6 spaced from each other in a direction X (Fig. 1). Each of the X-energization lead electrode 8a and the X-ground lead electrode 8b is a strip-shape transparent conductive thin sheet made of silver. When the operating panel 3 and the support board 4 are stacked together, these lead electrodes 8a and 8b are electrically connected respectively to signal lead patterns 12a and 12b formed and arranged on the front surface of the support board 4, and are led at an outer peripheral portion of the support board 4 to the connecting portion for the connector tail 5 respectively by these signal lead patterns 12a and 12b.

Similarly, at the front surface of the support board 4, a Y-energization lead electrode 9a and a Y-ground lead electrode 9b, electrically connected to the fixed conductive layer 7, are printed respectively on opposite side edge portions of the fixed conductive layer 7 spaced from each other in a direction Y (Fig. 1) perpendicular to the direction X. Each of the Y-energization lead electrode 9a and the Y-ground lead electrode 9b is made of a strip-shape transparent conductive thin sheet made of silver. These lead electrodes 9a and 9b are led at the outer peripheral portion of the support board 4 to the connecting portion for the connector tail 5 respectively by signal lead patterns 12c and 12d (to which these lead electrodes 8a and 8b are electrically connected by a conductive adhesive, respectively) formed and arranged on the front surface of the support board 4.

A pair of piezoelectric plates 2 and 2 are fixedly secured to the rear surface of the support board 4. Each piezoelectric plate 2 is a single-layer plate made of a piezoelectric material such as a piezoelectric monocrystal, a piezoelectric ceramics material (represented by PZT (lead zirconate titanate porcelain) and polyvinylidene fluoride (PVDF). Here, each piezoelectric plate 2 is formed into a strip-shape thin sheet as shown in the drawings, using a piezoelectric ceramics sheet composed of a most extensively-used PZT piezoelectric porcelain material. The piezoelectric plate 2 is thus formed into a strip-shape thin sheet so that a larger strain can develop in the piezoelectric plate 2 when a drive voltage is applied to front and rear surfaces thereof.

The pair of drive electrodes 2a and 2b for applying a drive voltage to the piezoelectric plate 2 are formed by depositing a conductive material on the opposite (front and rear) surfaces of the piezoelectric plate 2 by vapor deposition, screen printing or the like, and then by calcining these deposited layers to thereby fixing these layers to the opposite surfaces of the piezoelectric plate. One drive electrode 2a covering the rear surface of the piezoelectric plate 2 is turned back at one longitudinal end thereof, and is exposed to the front surface of the piezoelectric plate 2, and is spaced from the other drive electrode 2b by a small insulating gap formed therebetween.

As shown in Fig. 2, the pair of piezoelectric plates 2 are fixedly secured to the rear surface of the support board 4, and extend adjacent to and along the opposite longitudinal side edges of this support board 4 (in the direction X), respectively, with the operating area 3a disposed therebetween. The drive electrodes 2a and 2b of the two piezoelectric plates 2 are led to the connecting portion for the connector tail 5 respectively by power lead patterns 13 (13a, 13b, 13c and 13d) formed on the rear surface of the support board 4 and arranged outside and along the outer periphery of the operating area 3a.

For securing each piezoelectric plate 2 to the support plate 4, since the drive electrodes 2a and 2b exposed to the fixing surface thereof are to be electrically connected to the power lead patterns 13a and 13b or 13c and 13d, in this embodiment, a conductive adhesive is used for securing the piezoelectric plate 12 to the support plate 4. In the present invention, the support board 4 is vibrated, utilizing an electrostrictive effect of the piezoelectric plates 2, and the piezoelectric plates 2 are fixedly secured directly to the support board 4, and therefore the expansion and contraction of each piezoelectric plate 2 produce a stress which causes a vibration of a large amplitude to be produced in the support board 4. For example, when an electric field of 10 x 10⁵ V/m is applied to a PZT-type piezoelectric material having a dielectric constant of 3400, a piezoelectric constant of 590 x 10¹² C/N and an elastic compliance of 20 x 10⁻¹² m²/N, a strain of 5.9 x 10⁴ develops, and when this strain is kept in a clamped condition, a large stress of 3 x 10⁷ N/m develops.

This electrostrictive effect is utilized, and when a drive voltage of ±280 V or so is applied between the pair of drive electrodes 2a and 2b, a vibration having a sufficient amplitude to enable the operator to perceive the vibration through the finger touching the operating panel 3 for an input operation is produced in the support board 4. Particularly, the piezoelectric plate 2 of a strip-shape shape is bent in its longitudinal direction, and therefore the piezoelectric plates 2, fixedly secured to the support board 4 in the longitudinal direction thereof, can effectively vibrate the whole of the support board 4 at a large amplitude.

As shown in Fig. 4, the connector tail 5 is a flexible printed circuit board (hereinafter referred to as "FPC") which comprises a flexible strip-shape substrate made of polyimide, and a plurality of conductor wires comprising conductive printed patterns formed on this substrate and extending in a longitudinal direction thereof. A proximal end portion of the connector tail 5 to be connected to the touch panel (support board) 4 is bifurcated to provide a power cable portion 5A and a signal cable portion 5B. A distal end portion of the connector tail serves as a connector connection portion 5C for insertion into an FPC connector 20 shown in Fig. 1.

As shown in Fig. 4C, four conductor wires 14 (14a, 14b, 14c and 14d) are formed and arranged on a rear surface of the connector tail 5 at a predetermined pitch (i.e., at equal intervals), and extend from the signal cable portion 5B to the connector connection portion 5C in a leading-out direction. As shown in Fig. 4A, four power conductor wires 15 (15a, 15b, 15c and 15d) are formed and arranged on a front surface of the connector tail 5 at a pitch twice larger than the pitch of the signal conductor wires 14, and extend from the power cable portion 5A toward the distal end of the connector tail 5 in the leading-out direction. Distal ends of these power conductor wires 15 are exposed to the rear surface of the connector tail through respective through holes 16 at the connector connection portion 5C.

Opposite ends of the signal conductor wires 14 and power conductor wires 15 are made wider so as to be easily electrically connected to the lead patterns 12 and 13 and contacts (not shown) of the FPC connector 20. Except these wider opposite ends, the conductor wires 14 and 15 are covered with insulative protecting sheets 10a and 10b as shown in Fig. 4B so as to be prevented from short-circuiting and deterioration.

As shown in Figs. 2 and 3, the four power conductor wires 15 (15a, 15b, 15c and 15d), exposed to the front surface of the connector tail 5, are superposed respectively on the corresponding four power lead patterns 13a, 13b, 13c and 13d (formed on the rear surface of the support board 4 and led to the peripheral edge of the support board 4) at the power cable portion 5A, and are electrically connected respectively to these power lead patterns 13 by thermocompression welding. In this thermocompression welding process, the distal ends of the four power lead patterns 13, extending from the pair of piezoelectric plates 2, are located generally at the same position, and are collectively pressed against the respective power conductor wires 15 at the power cable portion 5A, and therefore a generally uniform pressure is applied to all of the lead patterns 13, thereby preventing the incomplete connection due to a variation in the applied pressure.

The four signal conductor wires 14 (14a, 14b, 14c and 14d), exposed to the rear surface of the connector tail 5, are superposed respectively on the corresponding four signal lead patterns 12 (12a, 12b, 12c and 12d) (formed on the front surface of the support board 4 and led to the peripheral edge of the support board 4) at the signal cable portion 5B, and are electrically connected respectively to these signal lead patterns 12 by thermocompression welding as described above. Thus, the proximal end portion of the connector tail 5 is bifurcated, and the electrical connection of the connector tail 5 to the signal lead patterns 12 and the electrical connection of the connector tail 5 to the power lead patterns 13 are effected respectively at the front and rear sides (surfaces) of the touch panel 4 separately from each other. Therefore, by using the single connector tail 5, the signal lead patterns 12 and the power lead patterns 13 are arranged respectively on the front and rear surfaces of the touch panel 4 in a separate manner, and the wiring can be installed concisely without the need for considering the insulation of the lead patterns 12 and 13 from each other by jumper wires or the like.

When the connector connection portion 5C is inserted into the FPC connector 20 shown in Fig. 1, the signal conductor wires 14 (14a, 14b, 14c and 14d) and power conductor wires 15 (15a, 15b, 15c and 15d) which are exposed at the connector connection portion 5C are resiliently contacted respectively with the corresponding contacts of the FPC connector 20 provided in a projected manner within this connector 20. The arrangement pitch of of the contacts of the FPC connector 20 corresponds to the arrangement pitch of the signal conductor wires 14, and therefore the power conductor wires 15, arranged at the pitch twice larger than the pitch of the signal conductor wires 14, are resiliently contacted with the alternate contacts, respectively. The connector connection portion 5C is formed of a thin flexible material, and therefore a reinforcing sheet 10c is bonded to the surface of the connector connection portion 5C in order to increase the rigidity thereof for easy insertion purposes and also to increase the thickness of the connector connection portion 5C to thereby increase the pressure of contact thereof with the contacts (see Fig. 4B).

The contacts of the FPC connector 20 are connected to an external control circuit (not shown), so that the electrodes 8a, 8b, 9a ad 9b of the touch panel, as well as the drive electrodes 2a and 2b of the pair of piezoelectric plates 2, are led to the exterior via the connector tail 5, and are electrically connected to the external control circuit.

When the touch panel input device 1 of this construction is in a standby condition in which any input operation is not detected, a predetermined input operation detection voltage is applied to the X-energization lead electrode 8a or the X-ground lead electrode 8b via the signal lead pattern 12a, 12b, so that the movable conductive layer 6 is kept at this potential, and also the signal lead patterns 12c and 12d, connected to the other fixed conductive layer 7, are grounded via resistors, and the potential of these lead patterns 12c and 12d are monitored. When the conductive layers 6 and 7 are contacted with each other by an input operation, an electric current flows from the movable conductive layer 6 to the resistors, so that the potential of the fixed conductive layer 7 (the signal lead patterns 12c and 12d) (which is kept at the ground potential during the time when the operating panel 3 is not operated for input purposes) increases to a predetermined level. Therefore, a predetermined threshold value is set, and when an input detection signal of a potential, exceeding the threshold value, appears in the signal lead patterns 12c and 12d, it is decided that the input operation has been applied to the touch panel (operating panel) 3.

As a result of detecting this input operation, the external control circuit applies a drive voltage of ±280 V or so between the power lead patterns 13a and 13b and also between the power lead patterns 13c and 13d via the power conductor wires 15a, 15b, 15c and 15d of the connector tail 5, and therefore is applied to the drive electrodes 2a and 2b of the pair of piezoelectric plates 2. As a result, the piezoelectric plates 2 are bent in their longitudinal direction, and the support board 4 to which the piezoelectric plates 2 are fixedly secured is vibrated, and this vibration is transmitted to the finger of the operator via the operating panel 3 contacting the support board 4 at the position of the input operation, and the operator can know that the input operation has been detected.

The external control circuit, after applying the drive voltage to the piezoelectric plates 2, shifts into an operating mode for detecting the position of the input operation. For detecting the input operation position, the position in the direction X and the position in the direction Y are detected separately from each other. For detecting the input operation position in the direction X, a coordinate detection voltage is applied to the X-energization lead electrode 8a via the signal lead pattern 12a, and also the X-ground lead electrode 8b is grounded, and a potential gradient of a uniform inclination is formed in the movable conductive layer 6. The fixed conductive layer 7 for contact with the movable conductive layer 6 is set to a high impedance, and by doing so, the potential at the input operation position can be read from the potential of the fixed conductive layer 7, and an input of a voltage detection circuit (such as an A/D converter) of the external control circuit is connected via the signal power wire 14c, 14d to one of the signal lead patterns 12c and 12d connected respectively to the Y-energization lead electrode 9a and the Y-ground lead electrode 9b, and the potential at the contact position is read. The potential gradient of a uniform inclination is formed in the movable conductive layer 6, and therefore the potential at the contact position, that is, the potential of the signal lead pattern 12c, 12d, is proportional to the distance in the direction X from the X-ground lead electrode 8b toward the X-energization lead electrode 8a, and from this, the X coordinate of the input operation position is detected.

For detecting the input operation position in the direction Y, a potential gradient of a uniform inclination is formed in the fixed conductive layer 7 in the direction Y in a similar method as described above, and the potential of the contact position is read from a voltage detection circuit connected via the signal power wires 14a, 14b to the X-energization lead electrode 8a or the X-ground lead electrode 8b. The potential at the contact position is proportional to the distance in the direction Y from the Y-ground lead electrode 9b toward the Y-energization lead electrode 9a, and from this, the Y coordinate of the input operation position is detected.

The X and Y coordinates detection mode is repeated in this manner, and the position of the input operation applied to the operating area 3a is detected in the directions X and Y, and input position data, representing the X coordinate and the Y coordinate, is output to a processing apparatus (not shown) such as a personal computer.

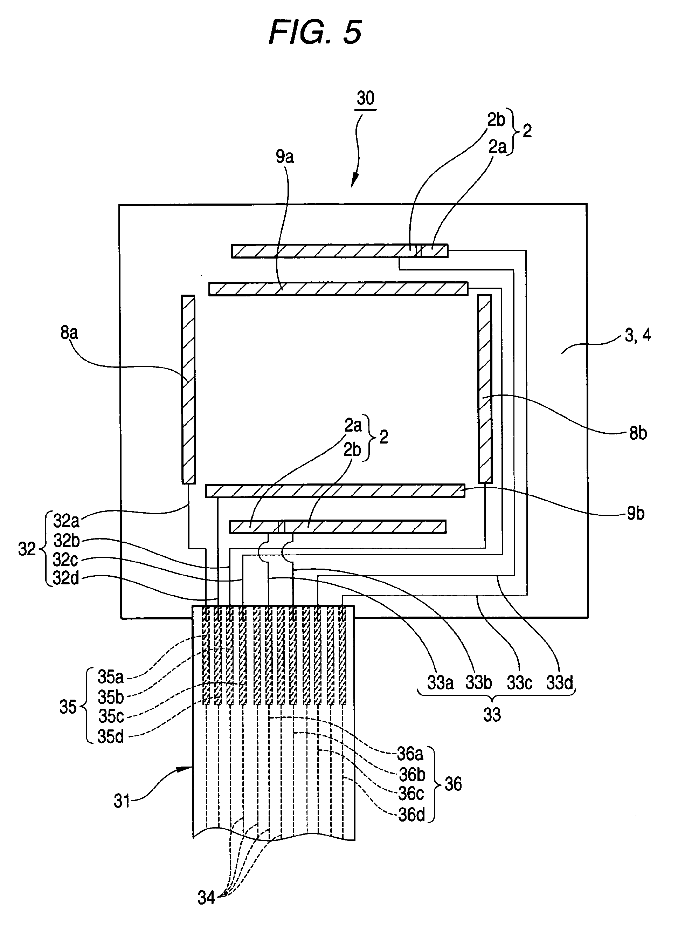

In the above embodiment, although the proximal end portion of the connector tail 5 is bifurcated, a general-purpose FPC can be used as a connector tail. Fig. 5 is a schematic view showing a touch panel input device 30 of this second embodiment, and those portions of the second embodiment which are identical in construction to the corresponding portions of the first embodiment will be designated by identical reference numerals, respectively, and explanation thereof will be omitted.

As shown in Fig. 5, a connector tail 31 comprises a strip-shape FPC, and in this embodiment, a plurality of conductor wires 34 are formed and arranged on a rear surface of the connector tail at a predetermined pitch (i.e., at equal intervals), and extend in a longitudinal direction thereof. Preferably, this arrangement pitch is an arrangement pitch defined in the Standard, and with this arrangement a distal end portion of the connector tail can be connected to a general-purpose FPC connector 20 having contacts arranged at the same pitch as the pitch of the conductor wires 34. Each of the conductor wires 34 is covered at its intermediate portion with a protecting sheet, and only its opposite end portions are made wider, and are exposed to the rear surface of the connector tail.

Thus, connecting surfaces of the conductor wires 34 are provided on the rear surface of the connector tail 31, and therefore signal lead patterns 32 (32a, 32b, 32c and 32d) and power lead patterns 33 (33a, 33b, 33c and 33d) are formed and arranged on the same surface (here, a front surface) of a touch panel 4. The pitch of the signal lead patterns 32 (32a, 32b, 32c and 32d), which are arranged at an outer peripheral portion of the touch panel 4 (which serves as the connecting portion for these signal lead patterns 32), is equal to the pitch of the conductor wires 34 of the connector tail 31, while the pitch of the power lead patterns 33 (33a, 33b, 33c and 33d) which are arranged at the connecting portion is twice larger than the pitch of the conductor wires 34.

Therefore, the connector tail 31 is superposed on the connecting portion to which the signal lead patterns 32 and the power lead patterns 33 are led, and at this position, the patterns 32 and 33 are thermocompression-welded respectively to the conductor wires 34 opposed respectively to these patterns 32 and 33. As a result, those conductor wires 34 which are electrically connected respectively to the signal lead patterns 32a, 32b, 32c and 32d in opposed relation thereto serve as signal conductor wires 35 (35a, 35b, 35c and 35d), while those alternate conductor wires 34 which are electrically connected respectively to the power lead patterns 33a, 33b, 33c and 33d in opposed relation thereto serve as power conductor wires 36 (36a, 36b, 36c and 36d), and the pitch of the power conductor wires 36 is twice larger than the pitch of the signal conductor wires 35.

### Second Embodiment

In the touch panel input device 30 of this second embodiment, the present invention can be performed without the need for producing the specially-designed connector tail 5 of the first embodiment in which the pitch of the power conductor wires 15 is twice larger than the pitch of the signal conductor wires 14.

In the above first and second embodiments, the four power conductor wires 15, 36 of the connector tail 5, 31 are connected respectively to the four corresponding power lead patterns 13, 33 extending from the respective drive electrodes 2a and 2b of the pair of piezoelectric plates 2. However, there can be provided an arrangement in which two power lead patterns (for example, power lead patterns 13a and 13c), connected respectively to one drive electrodes 2a, 2b of the pair of piezoelectric plates 2, are collectively connected to one of a pair of power conductor wires, while two power lead patterns (13b and 13d), connected respectively to the other drive electrodes 2b, 2a of the pair of piezoelectric plates 2, are collectively connected to the other of the pair of power conductor wires so that the pair of piezoelectric plates 2 can be expanded and contracted by a drive voltage applied to the pair of power conductor wires. In this case, when the two power lead patterns, collectively joined together, are connected respectively to the drive electrodes 2a of the pair of piezoelectric plates 2, the pair of piezoelectric plates 2 are expanded and contracted in synchronism with each other. On the other hand, when the two power lead patterns, collectively joined together, are connected respectively to the drive electrode 2a of one piezoelectric plate 2 and the drive electrode 2b of the other piezoelectric plate 2, the pair of piezoelectric plates 2 are expanded and contracted in opposite phase with each other.

Although the above embodiments are directed to the analog touch panel input devices 1 and 30 of the so-called resistance sensitive tablet-type, the invention can be applied to a touch panel input device of any suitable type such as a capacitive coupling type, a magnetic coupling, a contact type and an optical coupling type. And besides, in the touch panel input device of any of the above types, an input operation does not always need to be effected by the finger, but can be effected by a pointing tool such as a stylus pen.

The touch panel to which the connector tail is connected may be either of the operating panel 3 and the support board 4, and in a touch panel input device having a different input detection system, the touch panel may comprise one or more panels.

Although the connector tail comprises the FPC, any other suitable cable such as a flat cable can be used as the connector tail. Although the connection of the signal lead patterns to the signal conductor wires, as well as the connection of the power lead patterns to the power conductor wires, is made by thermocompression welding, any other suitable connecting method such as soldering can be used.

The present invention is suited for the touch panel input device in which the input detection signal is output to the exterior by the use of the connector tail, and also the expansion and contraction of the piezoelectric plates are controlled from the exterior, and the vibration at an input operation position tells the operator that the input operation has been recognized.

## Claims

1. A touch panel input device comprising:
a touch panel having an operating area;
an input position detector for detecting an input operation applied to the operating area, which includes a plurality of signal lead patterns which are arranged on the touch panel and through which a detection signal of the detected input operation is output;
a piezoelectric plate that is secured to the touch panel and is adapted to expand and contract to vibrate the touch panel in response to a drive voltage that is generated based on the detection signal;
a pair of power lead patterns that are arranged on the touch panel and through which the drive voltage is applied to the piezoelectric plate; and
a connector tail which includes a plurality of signal conductor wires connected respectively to the corresponding signal lead patterns, and a plurality of power conductor wires connected respectively to the corresponding power lead patterns, wherein the signal conductor wires and the power conductor wires are led from a peripheral edge of the touch panel and are arranged to extend in a leading-out direction,
wherein a pitch of the power conductor wires is substantially twice larger than a pitch of the signal conductor wires.

2. The touch panel input device according to claim 1, wherein the input position detector detects an input operation position an the touch panel and outputs input detection signals representing the input Operation position.

3. The touch panel input device according to claim 1 or 2, wherein the piezoelectric plate includes a pair of drive electrodes to which the drive voltage is applied via the pair of power lead patterns.

4. The touch panel input device according to one of claims 1 to 3, wherein a pair of the piezoelectric plates are secured to the touch panel.

5. The touch panel input device according to one of claims 1 to 4, wherein
the connector tail includes a plurality of conductor wires arranged at same pitch as the pitch o the signal conductor wires, and
the plurality of conductor wires are alternately connected respectively to the power lead patterns to nerve as the power conductor wires.

6. The touch panel input device according to one of Claims 1 to 5, wherein one end portion of the connector tail is bifurcated to provide a power cable portion having the power conductor wires and a signal cable portion having the signal conductor wires, and the power conductor wires on the power gable portion are electrically connected respectively to the power lead patterns at one side of the touch panel to which the piezoelectric plate is secured, and the signal conductor wires on the signal cable portion are electrically connected respectively to the signal lead patterns at the other side of the touch panel facing away 10 from the one side thereof.

7. The touch panel input device according to one of claims 1 to 6, wherein one end portion of the connector tail is bifurcated to provide a power cable portion having the power conductor wires and a signal cable portion having the signal conductor wires, and
the power conductor wires an the power cable portion are electrically connected respectively to the power lead patterns that are connected respectively to the drive electrodes of the pair of piezoelectric plates that are secured to the touch panel with the operation area between the pair of piezoelectric plates, and the signal conductor wires an the signal cable portion are electrically connected respectively to the signal lead patterns.

8. The touch panel input device according to one of claims 1 to 7, wherein two power lead patterns connected respectively to one pair of the drive electrodes of respective one of the pair of piezoelectric plates are collectively connected respectively to one of the pairs of power conductor wires,
two power lead patterns connected respectively to the other pair of the drive electrodes of the pair of piezoelectric plates are collectively connected to the other pair of power conductor wires, and the pair of piezoelectric plates secured to the touch panel are expanded and contracted by the drive voltage applied to the pairs of power conductor wires.

9. The touch panel input device according to one of claims 1 to 8, wherein two power lead patterns connected respectively to a pair of the drive electrodes of the pair of piezoelectric plates are collectively connected respectively to one of the pairs of power conductor wires, two power lead patterns connected respectively to the other pair of the drive electrodes of the pair of piezoelectric plates are collectively connected to the other pair of power conductor wires, and the pair of piezoelectric plates secured to the touch panel are expanded and contracted by the drive voltage applied 25 to the pairs of power conductor wires.
